Europäisches Patentamt

European Patent Office

Office européen des brevets

(19)

(11) **EP 1 142 133 B1**

(12) # EUROPÄISCHE PATENTSCHRIFT

(45) Veröffentlichungstag und Bekanntmachung des Hinweises auf die Patenterteilung:
**12.11.2003 Patentblatt 2003/46**

(21) Anmeldenummer: **99963258.1**

(22) Anmeldetag: **19.11.1999**

(51) Int Cl.$^7$: **H03M 13/23**, **H04L 1/00**

(86) Internationale Anmeldenummer:
**PCT/DE99/03698**

(87) Internationale Veröffentlichungsnummer:
**WO 00/031880 (02.06.2000 Gazette 2000/22)**

(54) **VERFAHREN, BASISSTATION UND TEILNEHMERSTATION ZUR KANALKODIERUNG IN EINEM GSM-MOBILFUNKSYSTEM**

METHOD, BASE STATION AND SUBSCRIBER STATION FOR CHANNEL CODING IN A GSM MOBILE RADIOTELEPHONE SYSTEM

PROCEDE, STATION DE BASE ET STATION MOBILE POUR CODAGE DE CANAL DANS UN SYSTEME DE RADIOCOMMUNICATION MOBILE GSM

(84) Benannte Vertragsstaaten:
**AT BE CH CY DE DK ES FI FR GB GR IE IT LI LU MC NL PT SE**

(30) Priorität: **19.11.1998 DE 19853443**

(43) Veröffentlichungstag der Anmeldung:
**10.10.2001 Patentblatt 2001/41**

(73) Patentinhaber: **SIEMENS AKTIENGESELLSCHAFT 80333 München (DE)**

(72) Erfinder:
- **HAGENAUER, Joachim D-82229 Seefeld (DE)**
- **HINDELANG, Thomas D-81373 München (DE)**
- **OESTREICH, Stefan D-83607 Holzkirchen (DE)**
- **XU, Wen D-82008 Unterhaching (DE)**

(56) Entgegenhaltungen:
- **HINDELANG T ET AL: "QUALITY ENHANCEMENT OF CODED AND CORRUPTED SPEECHES IN GSM MOBILE SYSTEMS USING REDIDUAL REDUNDANCY" IEEE INTERNATIONAL CONFERENCE ON ACOUSTICS, SPEECH, AND SIGNAL PROCESSING (ICASSP),US,LOS ALIMITOS,CA: IEEE COMP. SOC. PRESS,1997, Seiten 259-262, XP000789167 ISBN: 0-8186-7920-4**
- **JOHANNESSON R ET AL: "A LINEAR ALGEBRA APPROACH TO MINIMAL CONVOLUTIONAL ENCODERS" IEEE TRANSACTIONS ON INFORMATION THEORY,US,IEEE INC. NEW YORK, Bd. 39, Nr. 4, 1. Juli 1993 (1993-07-01), Seiten 1219-1233, XP000412044 ISSN: 0018-9448**
- **BURKERT F ET AL: "TURBO DECODING WITH UNEQUAL ERROR PROTECTION APPLIED TO GSM SPEECH CODING" GLOBAL TELECOMMUNICATIONS CONFERENCE (GLOBECOM),US,NEW YORK, IEEE,1996, Seiten 2044-2048, XP000748804 ISBN: 0-7803-3337-3**
- **FORNEY G D: "CONVOLUTIONAL CODES I: ALGEBRAIC STRUCTURE" IEEE TRANSACTIONS ON INFORMATION THEORY,US,IEEE INC. NEW YORK, Bd. 16, Nr. 6, 1. November 1970 (1970-11-01), Seiten 720-738, XP000577350 ISSN: 0018-9448**
- **BOSSERT, M.: "Kanalcodierung, Deckblatt und Seiten 284, 263-265, 271-272", 1998, TEUBNER, B.G., STUTTGART**

EP 1 142 133 B1

**Beschreibung**

Verfahren, Basisstation und Teilnehmerstation zur Kanalkodierung in einem GSM-Mobilfunksystem

Die Erfindung betrifft ein Verfahren, eine Basisstation und eine Teilnehmerstation zur Kanalkodierung in einem GSM-Mobilfunksystem.

Das GSM-Mobilfunksystem (global system for mobile communications) ist weltweit in mehr als 100 Netzen und für mehr als 100 Mio. Teilnehmer installiert. Im GSM-Mobilfunksystem werden Daten (beispielsweise Sprache oder Daten innerhalb von Datendiensten, wie SMS oder GPRS) mit Hilfe von elektromagnetischen Wellen über eine Funkschnittstelle übertragen. Die Funkschnittstelle bezieht sich auf eine Verbindung zwischen einer Basisstation und Teilnehmerstationen, wobei die Teilnehmerstationen Mobilstationen oder ortsfeste Funkstationen sein können. Das Abstrahlen der elektromagnetischen Wellen erfolgt dabei mit Trägerfrequenzen, die im GSM-Mobilfunksystem in den Frequenzbändern 900, 1800, 1900 MHz liegen.

Zur Übertragung der Daten über die Funkschnittstelle ist bei Mobilfunksystemen eine Kanalkodierung erforderlich. Diese Kanalkodierung unterscheidet sich für verschiedene Dienste, z. B. Daten 14.4 kbps, Sprache FR (full rate), Sprache HR (half rate). Ziel der Kanalkodierung und dazu komplementären Kanaldekodierung auf der Empfangsseite ist dabei eine möglichst niedrige Bitfehlerrate (BER).

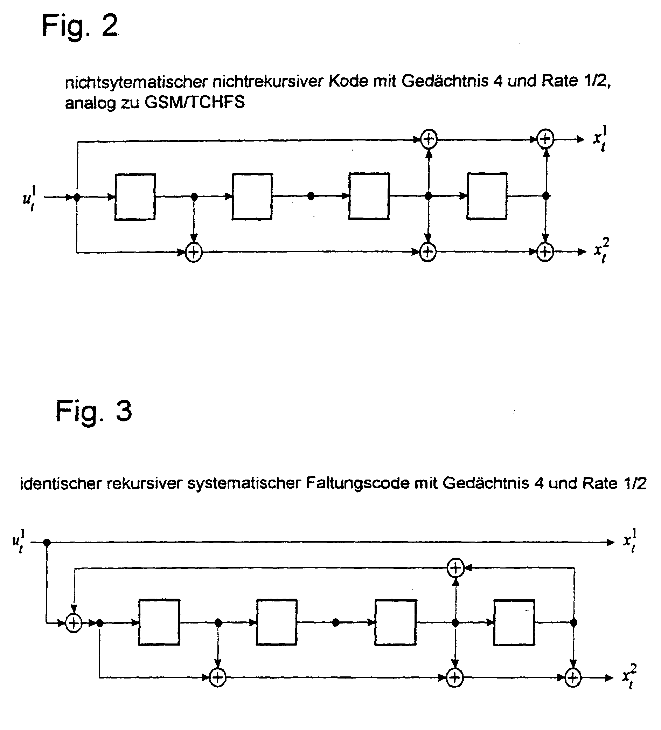

Bisher wurden im GSM-Mobilfunksystem (und anderen vergleichbaren Systemen) für die Kanalkodierung nur nichtsystematische nichtrekursive Faltungscodes (NSC-Kodes - non systematic convolutional) verwendet. Bei diesen Kodes wird ein kodiertes Bit durch Faltungskodierung aus einer gewichteten Summe des aktuellen und vergangener Nutzbits erzeugt. Bei einer Kodierrate von ½ werden so z. B. aus einem Nutzbit 2 kodierte Bits erzeugt (siehe Fig. 2), die jeweils einer unterschiedlich gewichteten Summe entstammen. Die Gewichte in dieser Summe und damit die Erzeugung der kodierten Bits werden durch die sog. Generator-Polynome bestimmt. So legt z. B. das Polynom $1 + D^3 + D^4$ fest, daß ein kodiertes Bit aus der Summe (XOR Verknüpfung) des aktuellen, des dritt- und des viertletzten Nutzbits entsteht.

Die bei der Kanalkodierung kodierten Bits werden über die Funkschnittstelle gesendet und empfangsseitig kanaldekodiert. Ein häufig genutzter Dekodieralgorithmus ist der sogenannte Viterbi-Algorithmus. Da der Dekodiervorgang gleichbleibend und zudem rechenintensiv ist, werden vor allem in Basisstationen dafür Hardwarebausteine (anwendungsspezifische Schaltkreise ASICs) eingesetzt. Diese ASICs können in der Regel nur ein bestimmtes Dekodierschema verarbeiten, bei GSM nur für nicht-rekursive Kodes.

Im Falle der Einführung eines neuen Sprachkodierverfahrens für GSM-Mobilfunksysteme basieren die bisher, siehe ETSI SMG11; Tdoc SMG11 205/98, 159/98 und 147/98, 28.9.98, für die Kanalkodierung vorgeschlagenen Verfahren ausschließlich auf nichtrekursiven Kodes, um die Kompatibilität mit der existierender und millionenfach verbreiteter Hardware sicherzustellen. Trotz der Beteiligung vieler Hersteller am Entwicklungsprozess. siehe Tdoc SMG11 205/98, 159/98 und 147/98, vom 28. 9.98, wurden andere Kodetypen als nicht verwendbar angesehen.

In F. Burkert u.a., "Turbo Decoding with Unequal Error Protection Applied to GSM Speech Coding", Global Telecommunications Conference (GLOBECOM), New York (US), IEEE, 1996, Seite 2044-2048, XP000748804, ISBN 0-7803-3337-3 ist ein Verfahren zur Kanalcodierung in einem GSM-Mobilfunksystem beschrieben, das rekursive systematische Codes verwendet.

Aus M. Bossert, "Kanalcodierung", 2. Auflage, 1998, B.G. Teubner, Stuttgart, ISBN 3-519-16143-5 ist bekannt, Faltungscodes mit einem Viterbi-Decoder, umfassend einen Sequenzschätzer und ein Modul zur inversen Abbildung, zu decodieren. Außerdem ist dort beschrieben, daß jede gebrochenrationale Generatormatrix eine äquivalente polynominale Generatormatrix besitzt, welche die gleiche Menge an Codewörtern erzeugt.

Der Erfindung liegt die Aufgabe zugrunde, ein Verfahren zur Kanaldekodierung und -dekodierung von rekursiven systematischen Codes und zur Durchführung des Verfahrens geeignete Einrichtungen anzugeben, die störungsrisikoselektiv codieren und keine Hardware-Änderungen an der bestehenden Infrastruktur in GSM-Mobilfunksystemen erforderlich machen. Diese Aufgabe wird durch das Verfahren mit den Merkmalen des Anspruchs 1 und die Einrichtungen mit den Merkmalen der Ansprüche 8 bzw. 11 gelöst.

Rekursive systematische Kodes (RSC-Codes) unterscheiden sich von den NSC-Kodes dadurch, daß z.B. bei Rate ½ das erste "kodierte" Bit dem aktuellen Nutzbit entspricht (systematisch) und das zweite kodierte Bit aus dem aktuellen und vergangenen Nutzbits als auch vergangenen kodierten Bits (rekursiv) entsteht. Es werden also rückgekoppelte Kodes verwendet, wobei ausgenutzt wird, daß rekursive systematische Kodes besonders bei hohen Bitfehlerraten deutlich bessere Kodeeigenschaften und somit auch bessere Eigenschaften bezüglich der Fehlerkorrektur besitzen.

Beim erfindungsgemäßen Verfahren wird empfangsseitig nach einer Kanaldekodierung mit Teilen des rekursiven systematischen Kodes eine Nachverarbeitung auf der Basis des Nennerpolynoms durchgeführt. Nach einer vorteilhaften Weiterbildung des Verfahrens erfolgt der Dekodiervorgang wie bisher mit einer Dekodierung eines NSC-Kodes und zwar dem, der identisch zu dem nichtrekursiven Anteil - dem Zählerpolynom - des neuen RSC-Kode ist. Nach dieser hardwarekompatiblen Dekodierung schließt sich eine Nachverarbeitung an, bei der die damit erhaltenen Bits nochmals mit dem Nennerpolynom kodiert werden. Diese Nachverarbeitung erfolgt vorteilhafterweise mit programmtechnischen Mitteln, also in Software, die leichter nachträglich in vorhandene Stationen ladbar ist.

Die RSC-Kodes, bekannt u.a. aus E.Offer, "Decodierung mit Qualitätsinformation bei verketteten Codiersystemen", Fortschrittsberichte, VDI-Verlag, Reihe 10, Band 443, Düsseldorf 1996, S.21ff und S.119ff, wurden bisher nicht eingesetzt, da sie Änderungen im Dekodiervorgang zur Folge haben und somit nicht hardwarekompatibel sind. Eine Einführung von RSC-Kodes bei der Kanalkodierung schien nicht möglich, da die installierten Basisstationen nachgerüstet werden mußten. Dies ist tatsächlich nicht der Fall, da sowohl sende- als auch empfangsseitig die Hardwarestruktur beibehalten werden kann und trotzdem RSC-Kodes zur Kanaldekodierung im GSM-Mobilfunksystem eingeführt werden können.

Die Kodierung der Nachverarbeitung ist nicht rechenaufwendig und kann in jeder Basisstation als Zusatzschritt durchgeführt werden. Durch diese Umkodierung erhält man bitexakt die Datensequenz der Sendeseite.

Ein rekursive Dekodierung, die nicht mit bisher installierter Hardware möglich ist, kann ersetzt werden durch eine Dekodierung in zwei nichtrekursiven aufeinanderfolgenden Einzelschritten. Der erste Schritt ist eine Dekodierung mit dem Zählerpolynom des rekursiven Kodes und der zweite Schritt ist eine Kodierung mit dem Nennerpolynom des rekursiven Kodes. Damit lassen sich auch mit einer bereits installierten Hardware ggf. beliebe systematische rekursive Kodes nachbilden. Der erste Schritt entspricht der bisherigen Dekodierung und der zweite Schritt ist die Nachverarbeitung.

Anhand der Fig 2 und 3 werden kurz die Polynome von identischen RSC- und NSC-Kodes erläutert. Bei einem typischen NSC - Kode (wie z.B. GSM/TCHFS).

Die Generatorpolynome lauten dort:

$$G_1 = 1 + D^3 + D^4$$

Polynome des NSC-Kodes:

$$G_2 = 1 + D + D^3 + D^4$$

Ein identischer RSC-Kode wird generiert, indem z.B. durch $G_1$ dividiert wird:

$$G_1 = 1$$

Polynome des RSC-Kodes:

$$G_2 = \frac{1 + D + D^3 + D^4}{1 + D^3 + D^4} ....$$

Diese RSC-Kodes haben den Vorteil, daß niedrigere Bitfehlerraten bei schlechten Kanälen (bis zu einer Bitfehlerrate von $10^{-4}$) möglich sind, da aufgrund der unkodierten Bits (systematischer Anteil) die Kanalfehlerrate nicht überschritten wird. Hingegen kann unter sehr schlechten Kanalbedingungen die Bitfehlerrate von kodierten Bits auch größer sein als die Kanalfehlerrate.

Nach einer vorteilhaften Ausbildung der Erfindung wird empfangsseitig a-priori-Wissen aus einer vorherigen Detektion gewonnen und dieses a-priori-Wissen bei einer nachfolgenden Kanaldekodierung verwendet. Bei der Übertragung kodierter Sprache ändern sich mehrere Sprachparameter und somit Bits nur selten oder man kann aus dem Wert diese Parameter in der Vergangenheit auch Voraussagen auf den wahrscheinlichen aktuellen Wert treffen. Weicht nun der empfangene aktuelle Wert deutlich von dem vorhergesagten Wert ab, so liegt mit hoher Wahrscheinlichkeit ein Übertragungsfehler vor und man kann z.B. den empfangenen durch den vorhergesagten Wert ersetzen.

Die Einbringung dieses Vorwissens (a-priori-Wissens) erfolgt im Kanaldekoder und war bisher meist unmöglich, da aufgrund der Verwendung nichtsystematischer Kodes der Dekodieralgorithmus modifiziert werden mußte. Die Modifikation war wiederum in der Regel nicht hardwarekompatibel. Werden RSC-Kodes eingesetzt, so kann dieses Vorwissen sehr einfach vor dem Dekodiervorgang eingebracht werden, da ein Teil der emfangenen Bits unkodiert ist. Der Dekodiervorgang selbst muß nicht modifiziert werden.

Wie bereits erläutert sind ein Teil der empfangenen Bits unkodierte Nutzbits. Sind die Kanalbedingungen gut, d.h. es sind keine Übertragungsfehler zu erwarten, so kann die Kanaldekodierung entfallen und es werden nur die Nutzbits verwendet. Die Übertragungsqualität kann dabei bereits vor dem Kanaldekoder festgestellt werden, indem vorteilhafterweise Informationen aus einem Kanalschätzer ausgewertet werden. Daraufhin wird entschieden, ob eine Dekodierung nötig ist oder nicht. Bei Teilnehmerstationen, bei denen der Energieverbrauch ein wesentliches Gütekriterium ist, ist ein wesentlicher Vorteil, daß der Kanaldekoder abgeschaltet werden kann. Damit wird Energie gespart. Außerdem kann bei Anwendungen - z.B. SMS-Anwendungen zur Anbindung von Telemetriediensten usw. -, bei denen immer mit hoher Übertragungsgüte gerechnet wird, die Hardware zur Kanaldekodierung ganz entfallen.

Durch eine nicht-rekursive Dekodierung mit nachfolgender Kodierung wird der Einsatz von RSC-Kodes in existierenden GSM-Mobilfunksystemen auf existierender Hardware mit den oben beschriebenen Vorteilen möglich.

Basierend auf der Netzstruktur des bekannten GSM-Mobilfunksystems nach Fig 1 und bezugnehmend auf die Kodes nach den Fig 2 und 3 wird ein Ausführungsbeispiel für die Erfindung näher erläutert.

Dabei zeigen

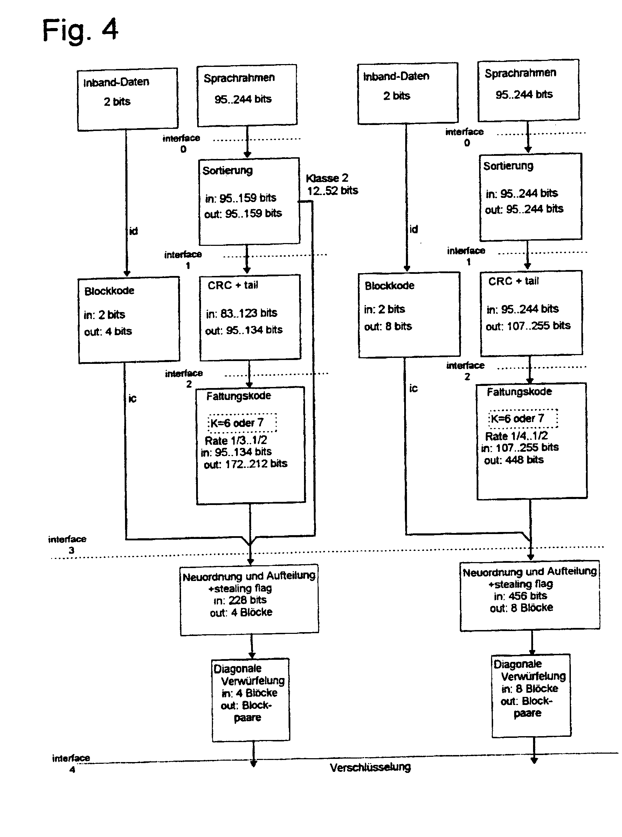

Fig 4    Ablaufdiagramm der Kodierung,

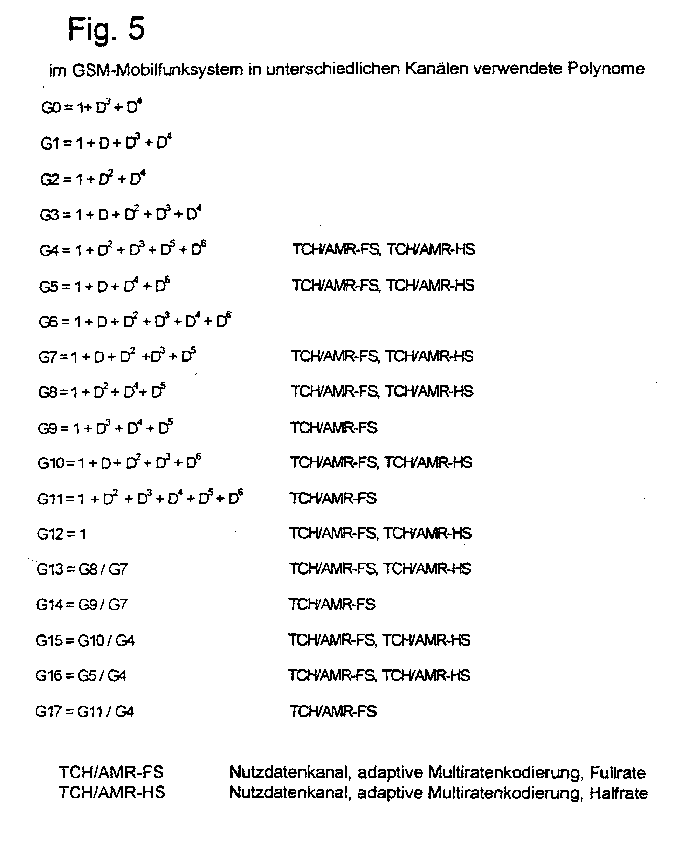

Fig 5    bei der Kodierung und Dekodierung verwendete Polynome, und

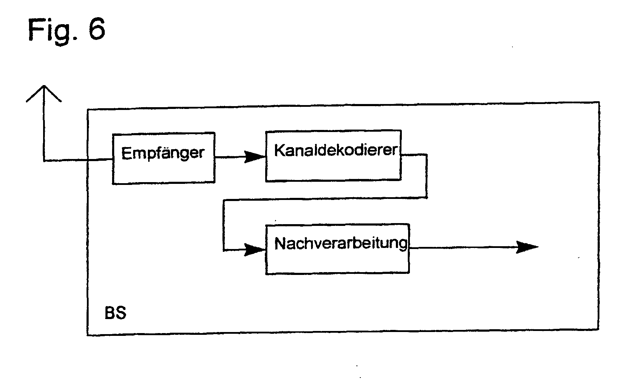

Fig 6    Ablaufdiagramm der Dekodierung.

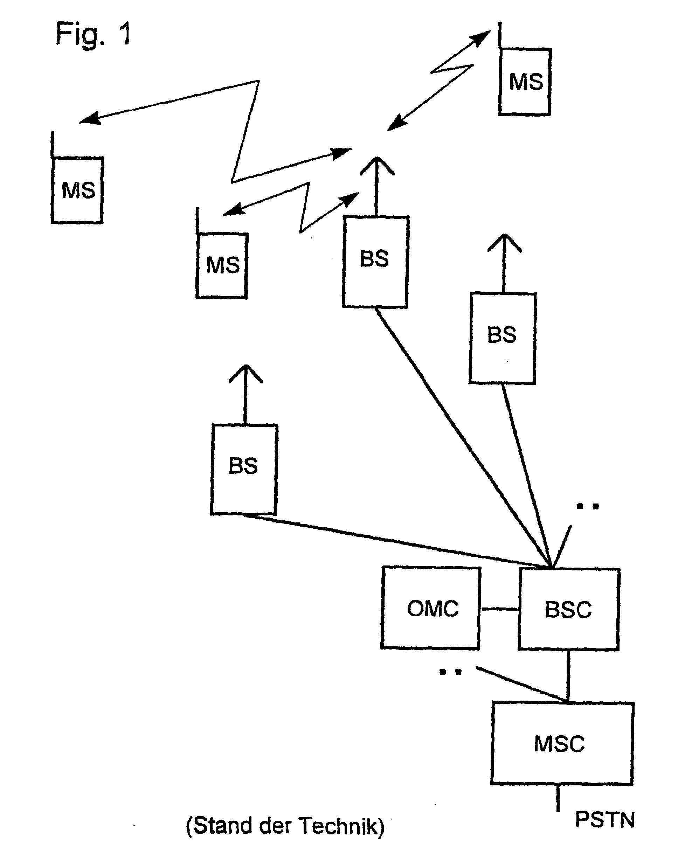

Das in Fig 1 dargestellte GSM-Mobilfunksystem besteht aus einer Vielzahl von Mobilvermittlungsstellen MSC, die untereinander vernetzt sind bzw. den Zugang zu einem Festnetz PSTN herstellen. Weiterhin sind diese Mobilvermittlungsstellen MSC mit jeweils zumindest einem Basisstationscontroller BSC zum Steuerung von Basisstationen BS verbunden. Jede dieser Basisstationscontroller BSC ermöglicht wiederum eine Verbindung zu zumindest einer Basisstation BS. Ein Operations- und Wartungszentrum OMC realisiert Kontroll- und Wartungsfunktionen für das Mobilfunksystem bzw. für Teile davon.

Eine Basisstation BS kann über eine Funkschnittstelle eine Verbindung zu Teilnehmerstationen, z.B. Mobilstationen MS oder anderweitigen mobilen und stationären Endgeräten aufbauen. Durch jede Basisstation BS wird zumindest eine Funkzelle gebildet. In Fig 1 sind Verbindungen zur Übertragung von Nutzinformationen zwischen einer Basisstation BS und Mobilstationen MS dargestellt.

Bei den gezeigten Kodierverfahren wird Sprachinformation als Nutzinformation übertragen. Die Bits der Sprachinformationen werden entsprechend ihrer Empfindlichkeit gegenüber Fehlern in drei Klassen bezüglich der Wichtigkeit eingeteilt (Klasse 1a, 1b und 2). Die wichtigsten Bits (Klasse 1a werden durch eine CRC-Fehlerschutzkodierung (cyclic redundancy check) zusätzlich geschützt. Die Bits der Klassen 1a und 1b werden faltungskodiert und punktiert. Die Verwürfelung der Daten nach der Kodierung wird beim AMR entsprechend der für FR und HR bisher eingeführten Verwürfelungs-Schemata durchgeführt.

Insgesamt werden 14 Kodierverfahren vorgestellt im Rahmen des AMR-Kodierer zwischen denen entsprechend der Übertragungsverhältnisse zu wählen ist. Davon sind acht Kodiermodi im Fullrate-Modus und sechs Kodiermodi im Halfrate-Modus einsetzbar.

| Übertrungsmodus | Modus der Kanalkodierung | Quellenkodierung Bit-Rate, Sprache | Netto Bitrate, Inband-Signalisierung | Kanalkodierung Bit-Rate, Sprache | Kanalkodierung Bitrate, Inband |
|---|---|---|---|---|---|
| TCH/FR | CH0-FS | 12.20 kbit/s (GSM EFR) | 0.10 bit/s | 10.20 kbit/s | 0.30 kbit/s |
| | CH1-FS | 10.20 kbit/s | 0.10 bit/s | 12.20 kbit/s | 0.30 kbit/s |
| | CH2-FS | 7.95 kbit/s | 0.10 bit/s | 14.45 kbit/s | 0.30 kbit/s |
| | CH3-FS | 7.40 kbit/s (IS-641) | 0.10 bit/s | 15.00 kbit/s | 0.30 kbit/s |
| | CH4-FS | 6.70 kbit/s | 0.10 bit/s | 15.70 kbit/s | 0.30 kbit/s |
| | CH5-FS | 5.90 kbit/s | 0.10 bit/s | 16.50 kbit/s | 0.30 kbit/s |
| | CH6-FS | 5.15 kbit/s | 0.10 bit/s | 17.25 kbit/s | 0.30 kbit/s |
| | CH7-FS | 4.75 kbit/s | 0.10 bit/s | 17.65 kbit/s | 0.30 kbit/s |
| TCH/HR | CH8-HS | 7.95 kbit/s | 0.10 bit/s | 3.25 kbit/s | 0.10 kbit/s |
| | CH9-HS | 7.40 kbit/s (IS-41) | 0.10 bit/s | 3.80 kbit/s | 0.10 kbit/s |
| | CH10-HS | 6.70 kbit/s | 0.10 bit/s | 4.50 kbit/s | 0.10 kbit/s |
| | CH11-HS | 5.90 kbit/s | 0.10 bit/s | 5.30 kbit/s | 0.10 kbit/s |
| | CH12-HS | 5.15 kbit/s | 0.10 bit/s | 6.05 kbit/s | 0.10 kbit/s |
| | CH13-HS | 4.75 kbit/s | 0.10 bit/s | 6.45 kbit/s | 0.10 kbit/s |

Ein Inband-Signalisierung mit 2 Bits Netto (4 bzw. 8 Bits Brutto nach einer Kodierung) pro Rahmen (20 ms) wird in alternierenden Rahmen zur Signalisierung des Kodiermodus oder zur Signalisierung der Übertragungsqualität genutzt. Mit den zwei Bits können vier Kodiermodi signalisiert werden. Diese Kodiermodi, zwischen denen mittels der Inband-Signalisierung hin- und hergeschaltet werden kann, müssen vorher ausgewählt sein.

Für alle Modi gilt folgende Reihenfolge der auszuführenden Schritte:

1. Informationen der Inband-Signalisierung werden mit einem Blockkode kodiert,
2. die Nutzinformationen werden nach ihrer Bedeutung (Klasse sortiert),
3. die geordneten Bits der Nutzinformationen werden mit einem systematischen Blockkode (CRC) kodiert, dabei werden Wörter mit Sprach- und Paritätsbits erzeugt,
4. diese kodierten Bits und der Rest der Klasse 1 Bits werden faltungskodiert,
5. die kodierten Bits werden punktiert, um die gewünschte Bitrate zu erhalten,
6. ungeschützte Bits werden in den Rahmen mit punktierten Daten eingefügt (nur für Halfrate-Modus),
7. die Bits werden neu geordnet und eine Verwürfelung (interleaving) der kodierten und Inband-Bits durchgeführt, dabei wird auch ein sogenanntes Stealing-Flag eingefügt.

Die im folgenden verwendeten Bezeichnungen haben folgende Bedeutung:

| | |
|---|---|
| k, j | Nummerierung der Bits in Datenblock oder Burst |
| $K_x$ | Anzahl der Bits in einem Block, x gibt Datentyp an |
| n | Nummerierung der Ausgangsdatenblöcke |
| N | ein ausgewählter Datenblock |
| B | Nummerierung von Bursts oder Blöcken |
| s(k) | Sprachinformation vor der Sortierung, $k=1..K_S$ (interface 0 in Fig 4) |
| d(k) | Sprachinformation vor der Kanalkodierung, $k=1..K_d-1$ (interface 1 in Fig 4) |
| id(k) | Bits der Inband-Signalisierung, k=0,1 |
| ic(k) | kodierte Bits der Inband-Signalisierung, k=0..3 (ER), 7 (FR) |
| u(k) | Daten nach erstem Kodierungsschritt, $k=0,1,..K_u-1$ (Blockkodierung, CRC-Kodierung) (interface 2 in Fig 4) |
| c(n,k), c(k) | Daten nach dem zweiten Kodierungsschritt, $k=0,1..K_c-1$, n=0,1..N,N+1 (Faltungskodierung), (interface 3 in Fig 4) |
| i(B,k) | verwürfelte Daten, $k=0, 1..K_j-1$, $B=B_0, B_0+1, ..$ |
| e(B,k) | Bits eines Bursts, k=0,1,114,115; $B= B_0, B_0+1, ..$ (interface 4 in Fig 4) |

**Kodierung im Fullrate Modus (FR)**

Kodierung der Bits der Inband-Signalisierung:

| id(0,1) | ic(0..7) |
|---------|----------|
| 00 | 00000000 |
| 01 | 10111010 |
| 10 | 01011101 |
| 11 | 11100111 |

Verteilung der Bits auf Klassen:

| Kodiermodus | Anzahl der Sprachbits pro Block | Anzahl der Klasse 1 Bits pro Block | Anzahl der Klasse 1a Bits pro Block | Anzahl der Klasse 1b Bits pro Block |
|---|---|---|---|---|
| CH0-FS | 244 | 244 | 81 | 163 |

(fortgesetzt)

| Kodiermodus | Anzahl der Sprachbits pro Block | Anzahl der Klasse 1 Bits pro Block | Anzahl der Klasse 1a Bits pro Block | Anzahl der Klasse 1b Bits pro Block |
|---|---|---|---|---|
| CH1-FS | 204 | 204 | 65 | 139 |
| CH2-FS | 159 | 159 | 75 | 84 |
| CH3-FS | 148 | 148 | 61 | 87 |
| CH4-FS | 134 | 134 | 55 | 79 |
| CH5-FS | 118 | 118 | 55 | 63 |
| CH6-FS | 103 | 103 | 49 | 54 |
| CH7-FS | 95 | 95 | 39 | 56 |

Es gibt keine Klasse 2 Bits.

Die wesentlichen Parameter für den Kodierer und korrespondierend für jeden Dekodierer sind für den ersten Kodierschritt folgendermaßen angegeben:

| Kodiermodus | Kodierte Sprachbits ($K_d$) | CRC-geschützte Bits ($K_{d1a}$) | Anzahl der Tai- Bits ($N_{tail}$) | Anzahl der Bits nach ersten Kodierschritt ($K_u = K_d + 6 + N_{tail}$) |
|---|---|---|---|---|
| CH0-FS | 244 | 81 | 5 | 255 |
| CH1-FS | 204 | 65 | 5 | 215 |
| CH2-FS | 159 | 75 | 6 | 171 |
| CH3-FS | 148 | 61 | 6 | 160 |
| CH4-FS | 134 | 55 | 6 | 146 |
| CH5-FS | 118 | 55 | 6 | 130 |
| CH6-FS | 103 | 49 | 6 | 115 |
| CH7-FS | 95 | 39 | 6 | 107 |

a) Paritäts-Bits (Parity bits):

Ein 6-Bit CRC (cyclic redundancy check) wird für die Fehlerdetektion benutzt. Diese 6 Paritäts-Bits werden mit folgenden zyklischen Generator-Polynom erzeugt:

$g(D) = D^6 + D^5 + D^3 + D^2 + D^1 + 1$ für die ersten $K_{d1a}$ Bits der Klasse, 1, wobei $K_{d1a}$ die Anzahl der Bits der Klasse 1a nach obenstehender Tabelle angibt. Die Kodierung mit den zyklischen Kode wird auf systematische Weise ausgeführt:

in GF(2), die Polynome:

$$d(0)D(K_{dla}+5) + d(1)D(K_{dla}+4) +... + d(K_{dla}-1)D(6) + p(0)D^{(5)} +...+ p(4)D+ p(5)$$

wobei p(0), p(1) ... p(5) die Paritätsbits sind, die

geteilt durch g(D) gleich "0" ergeben.

b) Tailing Bits und Neuordnung

Die Nutz- und Paritätsbits werden zusammengeführt und sogenannte Tailbits werden angehängt:

$u(k) = d(k)$ für k = 0, 1, ..., $K_{d1a}$-1

$$u(k) = p(k-K_{d1a}) \quad \text{für } k = K_{d1a}, K_{d1a}+1, ..., K_{d1a}+5$$
$$u(k) = d(k-6) \quad \text{für } k = K_{d1a}+6, K_{d1a}+7, ..., K_d+5$$
$$u(k) = \text{abhängig vom Kodiermodus}$$

Somit werden nach dem ersten Kodierschritt u(k) folgende Inhalte für jeden Kodiermodus definiert:

| | | |
|---|---|---|
| **CHO-FS:** | $u(k) = d(k)$ | für k = 0, 1, ..., 80 |
| | $u(k) = p(k-81)$ | für k = 81, 82, ..., 86 |
| | $u(k) = d(k-6)$ | für k = 87, 88, ..., 249 |
| | $u(k) = $ noch anzugeben | für k = 250, 251, ..., 254 |
| **CH1-FS:** | $u(k) = d(k)$ | für k = 0, 1, ..., 64 |
| | $u(k) = p(k-65)$ | für k = 65, 66, ..., 70 |
| | $u(k) = d(k-6)$ | für k = 71, 72, .... 209 |
| | $u(k) = $ noch anzugeben | für k = 210, 211, ..., 214 |
| **CH2-FS:** | $u(k) = d(k)$ | für k = 0, 1, ..., 74 |
| | $u(k) = p(k-75)$ | für k = 75, 76, .., 80 |
| | $u(k) = d(k-6)$ | für k = 81, 82, ..., 164 |
| | $u(k) = $ noch anzugeben | für k = 165, 166, ..., 170 |
| **CH3-FS:** | $u(k) = d(k)$ | für k = 0, 1, ..., 60 |
| | $u(k) = p(k-61)$ | für k = 61, 62, ..., 66 |
| | $u(k) = d(k-6)$ | für k = 67, 68, ..., 153 |
| | $u(k) = $ noch anzugeben | für k = 154, 155, .., 159 |
| **CH4-FS:** | $u(k) = d(k)$ | für k = 0, 1, ..., 54 |
| | $u(k) = p(k-55)$ | für k = 55, 56, ..., 60 |
| | $u(k) = d(k-6)$ | für k = 61, 62, ..., 139 |
| | $u(k) = $ noch anzugeben | für k = 140, 141, ..., 145 |
| **CH5-FS:** | $u(k) = d(k)$ | für k = 0, 1, ..., 54 |
| | $u(k) = p(k-55)$ | für k = 55, 56, ..., 60 |
| | $u(k) = d(k-6)$ | für k = 61, 62, ..., 123 |
| | $u(k) = $ noch anzugeben | für k = 124, 125, ..., 129 |
| **CH6-FS:** | $u(k) = d(k)$ | für k = 0, 1, ..., 48 |
| | $u(k) = p(k-49)$ | für k = 49, 50, ..., 54 |
| | $u(k) = d(k-6)$ | für k = 55, 56, ..., 108 |
| | $u(k) = $ noch anzugeben | für k = 109, 110 ..., 114 |
| **CH7-FS:** | $u(k) = d(k)$ | für k = 0, 1, .... 38 |
| | $u(k) = p(k-39)$ | für k = 39, 40, ..., 44 |
| | $u(k) = d(k-6)$ | für k = 45, 46, ..., 100 |
| | $u(k) = $ noch anzugeben | für k = 101, 102, ..., 106 |

**Faltungskodierer**

Die Bits des ersten Kodierungsschritts (u(k)) werden mit einem rekursiven systematischen Faltungskode kodiert (siehe auch Fig 4). Die Zahl der Ausgabebits nach einer Punktierung und Wiederholung ist 448 Bits für alle Modi des Kodierverfahrens.

| Kodiermodus | Generator Polynome des Faltungskodes | Köderrate | Anzahl der eingehenden Bits in den Kodierer | Anzahl der durch den Kodierer ausgegeben Bits | Anzahl der punktierten Bits | Anzahl der wiederholten Bits |
|---|---|---|---|---|---|---|
| CH0-FS | G12,G13 | 1/2 | 255 | 510 | 62 | 0 |
| CH1-FS | G12, G13, G14 | 1/3 | 215 | 645 | 197 | 0 |
| CH2-FS | G12, G15, G16 | 1/3 | 171 | 513 | 65 | 0 |
| CH3-FS | G12, G15, G16 | 1/3 | 160 | 480 | 32 | 0 |
| CH4-FS | G12, G15, G16 | 1/4 | 146 | 584 | 136 | 0 |
| CH5-FS | G12, G15, G16, G17 | 1/4 | 130 | 520 | 72 | 0 |
| CH6-FS | G12, G15, G16, G17 | 1/4 | 115 | 460 | 12 | 0 |
| CH7-PS | G12, G15, G16, G17 | 1/4 | 107 | 428 | 19 | 39 |

Weitere Einzelheiten zur Kodierung/Dekodierung mit rekursiven Kodes wurden in C.Berrou, A.Glavieux, "Near Optimum errorcorrection coding and decoding: turbo codes" - "Reflections on the prize paper", IEEE Inf. Theory Soc. Newsletter, vol.48. No. 2, Juni 1998 und C.Berrou and A.Glavieux: "Near optimum error-correcting coding and decoding: turbo codes", IEEE Trans. on Comm., vol.44, pp. 1261-1271, Oktober 1996, gegeben.

Die Kodiermodi werden in Folge vorgestellt:

**CHO-FS:**

Ein Block von 255 Bits {u(0)... u(254)} wird mit der Rate 1/2 unter Verwendung folgender Polynome kodiert:

$$G12 = 1$$

$$G13 = (1 + D^2 + D^4 + D^5) / (1 + D + D^2 + D^3 + D^5)$$

Die Kodierung mit G12=1 bedeutet, daß das Eingangsbit nur mit 1 multipliziert wird, d. h. unkodiert übertragen wird. Aus jedem Eingangsbit wird durch die Kodierung mit G12 bzw. G13 jeweils ein Ausgangsbit erzeugt. Diese erscheinen hintereinander am Ausgang des Kodierers.
Somit resultiert aus einer seriellen Eingangsfolge von 255 Eingangsbits am Ausgang des Kodierers eine serielle Folge von 510 kodierten Bits, {C(0)... C(509)} definiert durch:

C(2k)         = u(k)
C(2k+1)        = u(k)+u(k-2)+u(k-4)+u(k-5)+C(2k-1)+C(2k-3)+ C(2k-5)+C(2k-9)

für k = 0, 1, ..., 254; u(k) = 0 für k<0: C(k) = 0 für k<0 Die Bits am Ausgang sind also abwechselnd mit G12 und G13 kodiert.
Der Kode ist punktiert, so daß die folgenden 62 kodierten Bits:
{C(4*j+1) for j = 79, 80,...,127 } und die Bits C(363),
C(379), C(395), C(411), C(427), C(443),
C(459), C(475), C(491), C(495), C(499), C(503) and C(507) nicht übertragen werden.
Im Ergebnis liegt ein Block von 448 kodierten und punktierten Bits vor, P(0)...P(447) der an die Bits einer Inband-Signalisierung in c angehängt wird.

c(k+8) = P(k)        für k = 0, 1, ..., 447.

**CH1-FS:**

Ein Block von 215 Bits {u(0)... u(214)} wird mit der Rate 1/3 unter Verwendung folgender Polynome kodiert:

G12 = 1
G13 = (1 + D$^2$ + D$^4$+ D$^5$) / (1 + D + D$^2$ + D$^3$ + D$^5$)
G14 = (1 +D$^3$ + D$^4$ + D$^5$) / (1 + D + D$^2$ + D$^3$ + D$^5$)

somit resultieren 645 kodierte Bits, (C(0)... C(645)} definiert durch:

C(3k)        =        u(k)
C(3k+1)        =        u(k)+u(k-2)+u(k-4)+u(k-5)+C(3k-2)+ C(3k-5)+C(3k-8)+C(3k-14)
C(3k+2)        =        u(k)+u(k-3)+u(k-4)+u(k-5)+C(3k-1)+ C(3k-4)+C(3k-7)+C(3k-13)

für k = 0, 1, ..., 214; u(k) = 0 für k<0; C(k) = 0 für k<0 Der Kode ist punktiert, so daß die folgenden 197 kodierten Bits:

{C(12*j+5), C(12*j+8), C(12*j+11) for j = 0, 1, ..., 25,
{0(12*j+2), C(12*j+5), C(12*j+8), C(12*j+11)        für j = 26, 27, ..., 52}

und die Bits C(2), C(610) C(622), C(628), C(634), C(637), C(638), C(640), C(641), C(643) und C(644) nicht übertragen werden.

Im Ergebnis liegt ein Block von 448 kodierten und punktierten Bits vor, P(0)...P(447) der an die Bits einer Inband-Signalisierung in c angehängt wird.

$$c(k+8) = P(k) \qquad , \qquad \text{für } k = 0, 1, ..., 447.$$

**CH2-FS:**

Ein Block von a=171 Bits {u(0)... u(170)} wird mit der Rate 1/3 unter Verwendung folgender Polynome kodiert:

G12 = 1
$G15 = (1 + D + D^2 + D^3 + D^6) / (1 + D^2 + D^3 + D^5 + D^6)$
$G16 = (1 + D + D^4 + D^6) / (1 + D^2 + D^3 + D^5 + D^6)$

somit resultieren 513 kodierte Bits, {C(0)... C(512)} definiert durch:

C(3k)      = u(k)
C(3k+1)      = u(k)+u(k-1)+u(k-2)+u(k-3)+u(k-6)+C(3k-5)+      C(3k-8)+C(3k-14)+C(3k-17)
C(3k+2)      = u(k)+u(k-l)+ u(k-4)+u(k-6)+C(3k-4)+C(3k-7)+       C(3k-11)+C(3k-16)

für k = 0, 1, ..., 170; u(k) = 0 für k<0; C(k) = 0 für k<0
Der Kode ist punktiert, so daß die folgenden 65 kodierten Bits:
{ C(21*j+20)      for j = 0, 1,...,15
C(21*j+8) C(21*j+11) C(21*j+17) C(21*j+20) for j = 16, 17,...,23 } und die Bits C(1), C(2), C(4), C(5), C(8), C(326), C(332), C(488), C(497), C(499), C(502), C(505), C(506), C(508), C(509), C(511) und C(512) nicht übertragen werden.
Im Ergebnis liegt ein Block von 448 kodierten und punktierten Bits vor, P(0)...P(447) der an die Bits einer Inband-Signalisierung in c angehängt wird.

$$c(k+8) = P(k) \qquad \text{für } k = 0, 1, ..., 447.$$

Der bei den Modi CH5-FS, CH6-FS, CH7-FS verwendeten Polynome sind:

$$G17 = (1 + D^2 + D^3 + D^4 + D^5 + D^6) / (1 + D^2 + D^3 + D^5 + D^6)$$

Für die Modi (CH3-FS, CH4-FS, CH5-FS, CH6-FS, CH7-FS) sind die bezeichnenden Werte:

**CH3-FS:**

C(3k)      = u(k)
C(3k+1)      = u(k)+u(k-1)+u(k-2)+u(k-3)+u(k-6)+C(3k-5)+ C(3k-8)+C(3k-14)+C(3k-17)
C(3k+2)      = u(k)+u(k-1)+ u(k-4)+u(k-6)+C(3k-4)+C(3k-7)+ C(3k-11)+C(3k-16)

für k = 0, 1, ..., 159; u(k) = 0 für k<0; C(k) = 0 für k<0
Die Bits {C(18*j+2), C(21*j+8), C(21*j+11), C(21*j+17) für j = 20, 21,...,25 } und C(353), C(359), C(470), C(473), C(475), C(476), C(478), C(479) werden nicht übertragen.

**CH4-FS:**

C(4k)      = u(k)
C(4k+1)      = u(k)+u(k-1)+u(k-2)+u(k-3)+u(k-6)+C(4k-7)+ C(4k-11)+C(4k-19)+C(4k-23)
C(4k+2)      = u(k)+u(k-l)+u(k-4)+u(k-6)+C(4k-6)+C(4k-10)+ C(4k-18)+C(4k-22)
C(4k+3)      = u(k)+u(k-2)+u(k-3)+u(k-4)+u(k-5)+u(k-6)+ C(4k-5)+C(4k-9)+C(4k-17)+C(4k-21)

für k = 0, 1, ..., 145; u(k) = 0 für k<0; C(k) = 0 für k<0

Die Bits {C(32*j+7) C(32*j+15) C(32*j+23) C(32*j+27) C(32*j+31) fürj = 0, 1, ..., 10
C(16*j+3) C(16*j+7) C(16*j+11) C(16*j+14) C(16*j+15) für j = 22, 23, ..., 35} und die Bits C(2), C(3), C(11), C(331), C(566), C(570), C(578), C(579), C(581), C(582) and C(583) werden nicht übertragen.

**CH5-FS:**

```
C(4k)       = u(k)
C(4k+1)     = u(k)+u(k-1)+u(k-2)+u(k-3)+u(k-6)+C(4k-7)+ C(4k-11)+C(4k-19)+C(4k-23)
C(4k+2)     = u(k)+u(k-1)+u(k-4)+u(k-6)+C(4k-6)+C(4k-10)+ C(4k-18)+C(4k-22)
C(4k+3)     = u(k)+u(k-2)+u(k-3)+u(k-4)+u(k-5)+u(k-6)+ C(4k-5)+C(4k-9)+ C(4k-17)+C(4k-21)
```

für k = 0, 1, ..., 129; u(k) = 0 für k<0; C(k) = 0 für k<0

Die Bits
{C(32*j+11), C(32*j+23), C(32*j+31) fürj = 0, 1,...,9 C(32*j+7), C(32*j+11), C(32*j+15), C(32*j+23), C(32*j+27), C(32-*j+31) für j = 10, 11,...,15}
und die Bits C(499), C(510), C(514), C(515), C(518), C(519) werden nicht übertragen.

**CH6-FS:**

```
C(4k)       = u(k)
C(4k+1)     = u(k)+u(k-1)+u(k-2)+u(k-3)+u(k-6)+C(4k-7)+ C(4k-11)+C(4k-19)+ C(4k-23)
C(4k+2)     = u(k)+u(k-1)+u(k-4)+u(k-6)+C(4k-6)+C(4k-10)+ C(4k-18)+C(4k-22)
C(4k+3)     = u(k)+u(k-2)+u(k-3)+u(k-4)+u(k-5)+u(k-6)+ C(4k-5)+C(4k-9)+C(4k-17)+C(4k-21)
```

für k = 0, 1, ..., 114; u(k) = 0 für k<0; C(k) = 0 für k<0

Die Bits
{C(16*j+11) for j = 22, 23,...,28} und die Bits C(450), C(451), C(454), C(455), C(458) werden nicht übertragen.

**CH7-FS:**

```
C(4k)       = u(k)
C(4k+1)     = u(k)+u(k-1)+u(k-2)+u(k-3)+u(k-6)+C(4k-7)+ C(4k-11)+C(4k-19)+ C(4k-23)
C(4k+2)     = u(k)+u(k-1)+u(k-4)+u(k-6)+C(4k-6)+C(4k-10)+ C(4k-18)+C(4k-22)
C(4k+3)     = u(k)+u(k-2)+u(k-3)+u(k-4)+u(k-5)+u(k-6)+ C(4k-5)+C(4k-9)+C(4k-17)+C(4k-21)
```

für k = 0, 1, ..., 94; u(k) = 0 für k<0; C(k) = 0 für k<0

Die Bits
C(1), C(2), C(3), C(6), C(7), C(11), C(367), C(383), C(399), C(407), C(415), C(418), C(419), C(421), C(422), C(423), C(425), C(426), C(427) werden entfernt. In diesem Block von 409 kodierten und punktierten Bits, P(0)... P(408), werden 39 Bits wiederholt:

$$P(409+k) = P(10+k*8) \text{ für } k = 0, 1, ..., 38$$

**Kodierung im Halfrate Modus (HR)**

Kodierung der Bits der Inband-Signalisierung:

| id(0,1) | ic(0..3) |
|---------|----------|
| 00 | 0000 |
| 01 | 1001 |
| 10 | 0111 |
| 11 | 1110 |

Verteilung der Bits auf Klassen:

| Kodiermodus | Anzahl der Sprachbits pro Block | Anzahl der Klasse 1 Bits pro Block | Anzahl der Klasse 1a Bits pro Block | Anzahl der Klasse 1b Bits pro Block | Anzahl der Klasse 2 Bits pro Block |
|-------------|----------|----------|----------|----------|----------|
| CH8-HS | 159 | 123 | 67 | 56 | 36 |
| CH9-HS | 148 | 120 | 61 | 59 | 28 |
| CH10-HS | 134 | 110 | 55 | 55 | 24 |
| CH11-HS | 118 | 102 | 55 | 47 | 16 |
| CH12-HS | 103 | 91 | 49 | 42 | 12 |
| CH13-HS | 95 | 83 | 39 | 44 | 12 |

Die wesentlichen Parameter für den Kodierer und korrespondierend für jeden Dekodierer sind für den ersten Kodierschritt folgendermaßen angegeben:

| Kodiermodus | Anzahl der Klasse 1 Bits ($K_{d1}$) | CRC-geschützte Bits ($K_{d1a}$) | Anzhal der Tail-Bits ($N_{tail}$) | Anzahl der Ausgabebits nach dem ersten Kodierschritt ($K_{u} = K_{d1} + 6\, N_{tail}$) |
|-------------|----------|----------|----------|----------|
| CH8-HS | 123 | 67 | 5 | 134 |
| CH9-HS | 120 | 61 | 5 | 131 |
| CH10-HS | 110 | 55 | 5 | 121 |
| CH11-HS | 102 | 55 | 5 | 113 |
| CH12-MS | 91 | 49 | 6 | 103 |
| CH13-HS | 83 | 39 | 6 | 95 |

Die Angaben zu den Paritäts- und Tail-bits sowie zur Neuordnung entsprechend dem Fullrate-Modus.
Nach dem ersten Kodierschritt u(k) werden folgende Inhalte für jeden Kodiermodus definiert:

| CH8-HS: | u(k) = d(k) | für k = 0, 1, ..., 66 |
|---------|-------------|----------------------|
| | u(k) = p(k-67) | für k = 67, 68, ..., 72 |
| | u(k) = d(k-6) | für k = 73, 74, ..., 128 |
| | u(k) = noch anzugeben | für k = 129, 130, ..., 133 |
| CH9-HS: | u(k) = d(k) | für k = 0, 1, ..., 60 |

(fortgesetzt)

|  | | |
|---|---|---|
| | u(k) = p(k-61) | für k = 61, 62, ..., 66 |
| | u(k) = d(k-6) | für k = 67, 68, ..., 125 |
| | u(k) = noch anzugeben | für k = 126, 127, ..., 130 |
| **CH10-HS:** | u(k) = d(k) | für k = 0, 1, ..., 54 |
| | u(k) = p(k-55) | für k = 55, 56, ..., 60 |
| | u(k) = d(k-6) | für k = 61, 62, ..., 115 |
| | u(k) = noch anzugeben | für k = 116, 117, ..., 120 |
| **CH11-HS:** | u(k) = d(k) | für k = 0, 1, ..., 54 |
| | u(k) = p(k-55) | für k = 55, 56, .... 60 |
| | u(k) = d(k-6) | für k = 61, 62, ..., 107 |
| | u(k) = noch anzugeben | für k = 108, 109, ..., 112 |
| **CH12-HS:** | u(k) = d(k) | für k = 0, 1, ..., 48 |
| | u(k) = p(k-49) | für k = 49, 50, ..., 54 |
| | u(k) = d(k-6) | für k = 55, 56, ..., 96 |
| | u(k) = noch anzugeben | für k = 97, 98 ..., 102 |
| **CH13-HS:** | u(k) = d(k) | für k = 0, 1, ..., 38 |
| | u(k) = p(k-39) | für k = 39, 40, ..., 44 |
| | u(k) = d(k -6) | für k = 45, 46, ..., 88 |
| | u(k) = noch anzugeben | für k = 89, 90, ..., 94 |

## Faltungskodierer

Die Bits des ersten Kodierungsschritts (u(k)) werden mit einem systematischen rekursiven Faltungskode kodiert (siehe auch Fig 4). Die Zahl der Ausgabebits nach einer Punktierung und Wiederholung ist 448 Bits für alle Modi des Kodierverfahrens.

| Kodiermodus | Generator-Polynome für den Faltungskodierer | Anzahl der eingehenden Bits in den Kodierer | Kodier rate | Anzahl der durch den Kodierer ausgegeben Bits | Anzahl der punktierten Bits |
|---|---|---|---|---|---|
| CH8-HS | G12, G13 | 134 | 1/2 | 268 | 80 |
| CH9-HS | G12, G13 | 131 | 1/2 | 262 | 66 |
| CH10-HS | G12, G13 | 121 | 1/2 | 242 | 42 |
| CH11-HS | G12, G13 | 113 | 1/2 | 226 | 18 |
| CH12-HS | G12, G15, G16 | 103 | 1/3 | 309 | 97 |
| CH13-HS | G12, G15, G16 | 95 | 1/3 | 285 | 73 |

Die Kodiermodi werden in Folge vorgestellt:

**CHB-HS:**

Jeweils ein Block von 134 Bits {u(0)... u(133)} wird mit der Rate 1/2 unter Verwendung folgender Polynome kodiert:

G12 = 1
G13 = $(1 + D^2 + D^4 + D^5) / (1 + D + D^2 + D^3 + D^5)$

somit resultieren 268 kodierte Bits, {C(0)... C(267)} definiert durch:

C(2k)    = u(k)

$$C(2k+1) \qquad = u(k)+u(k-2)+u(k-4)+u(k-5)+C(2k-1)+C(2k-3)+ C(2k-5)+C(2k-9)$$

für k = 0, 1, ..., 133; u(k) = 0 für k<0; C(k) = 0 für k<0

Der Kode ist punktiert, so daß die folgenden 80 kodierten Bits:

{C(8*j+3), C(8*j+7) for j = 0, 1,...,21

C(8*j+3), C(8*j+5), C(8*j+7) für j = 22, 23,...,32} und die Bits C(1), C(265) und C(267)

nicht übertragen werden.

Im Ergebnis liegt ein Block von 188 kodierten und punktierten Bits vor, P(0)...P(187) der an die Bits einer Inband-Signalisierung in c angehängt wird.

$$c(k+4) = P(k) \qquad \text{für k = 0, 1, ..., 187.}$$

Schließlich werden 36 Klasse 2 Bits angehängt an c

$$c(192+k ) = d(123+k) \qquad \text{für k = 0, 1, ..., 35.}$$

**CH9-HS:**

Die 262 kodierten Bits {C(0)... C(261)}

$$C(2k) \qquad = u(k)$$
$$C(2k+1) \qquad = u(k)+u(k-2)+u(k-4)+u(k-5)+C(2k-1)+C(2k-3)+ C(2k-5)+C(2k-9)$$

für k = 0, 1, ..., 130; u(k) = 0 für k<0; C(k) = 0 für k<0 werden punktiert, so daß 66 kodierte Bits:

{C(16*j+3), C(16*j+7), C(16*j+11) for j = 0, 1, ..., 7 C(16*j+3), C(16*j+7), C(16*j+11), C(16*j+15) for j = 8, 9, ..., 15} und die Bits C(1),

C(221), C(229), C(237), C(245), C(249), C(253), C(257), C(259) und C(261) nicht übertragen werden.

Ein Block von 196 kodierten und punktierten Bits, P(0)...P(195) wird an die Bits der Inband-Signalisierung in c angehängt: c(k+4) = P(k) für k = 0, 1, ..., 195.

Schließlich werden 28 Klasse 2 Bits an c angehängt:

$$c(200+k ) = d(120+k) \qquad \text{für k = 0, 1, ..., 27.}$$

**CH10-HS:**

Die 242 kodierten Bits, {C(0)... C(241)}:

$$C(2k) \qquad = u(k)$$
$$C(2k+1) \qquad = u(k)+u(k-2)+u(k-4)+u(k-5)+C(2k-1)+C(2k-3)+ C(2k-5)+C(2k-9)$$

für k = 0, 1, ..., 106; u(k) = 0 für k<0; C(k) = 0 für k<0 werden punktiert, so daß 42 kodierte Bits:

{C(8*j+3) für j = 0, 1,...,21

C(8*j+3), C(8*j+7) für j = 22, 23, ..., 29} und die Bits

C(1), C(233), C(237) und C(241) nicht übertragen werden.

Ein Block von 200 kodierten und punktierten Bits, P(0)...P(199) wird an die Bits der Inband-Signalisierung in c angehängt: c(k+4) = P(k) für k = 0, 1, ..., 199.

Schließlich werden 24 Klasse 2 Bits an c angehängt:

$$c(204+k ) = d(110+k) \qquad \text{für k = 0, 1, ..., 23.}$$

**CH11-HS:**

Die 226 kodierten Bits, {C(0)... C(225)}:

$$C(2k) \qquad = u(k)$$
$$C(2k+1) \qquad = u(k)+u(k-2)+u(k-4)+u(k-5)+C(2k-1)+C(2k-3)+ C(2k-5)+C(2k-9)$$

für k = 0, 1, ..., 112; u(k) = 0 für k<0; C(k) = 0 für k<0 werden punktiert, so daß 18 kodierte Bits:
{C(28*j+15) für j = 0, 1,...,7 } und die Bits C(1), C(3), C(7), C(197), C(213), C(215), C(217), C(221), C(223) und C(225) nicht übertragen werden.

Ein Block von 208 kodierten und punktierten Bits, P(0)...P(207) wird an die Bits der Inband-Signalisierung in c angehängt: c(k+4) = P(k) für k = 0, 1, ..., 207.

Schließlich werden 16 Klasse 2 Bits an c angehängt:

c(212+k ) = d(96+k) für k = 0, 1, ..., 15.

**CH12-HS:**

Die 309 kodierten Bits, (C(0)... C(308)}:

C(3k)       = u(k)
C(3k+1)     = u(k)+u(k-1)+u(k-2)+u(k-3)+u(k-6)+C(3k-5)+ C(3k-8)+ C(3k-14)+ C(3k-17)
C(3k+2)     = u(k)+u(k-1)+ u(k-4)+u(k-6)+C(3k-4)+C(3k-7)+ C(3k-11)+ C(3k-16)

für k = 0, 1, ..., 102; u(k) = 0 für k<0; C(k) = 0 für k<0 werden punktiert, so daß 97 kodierte Bits:
{C(12*j+5), C(12*j+8), C(12*j+11) für j = 0, 1,...,15 C(12*j+2), C(12*j+5), C(12*j+8), C(12*j+11) für j = 16, 17,...,24} und die Bits C(1), C(2), C(4), C(7), C(292), C(292), C(295), C(298), C(301), C(302) C(304), C(305), C(307) und C(308) nicht übertragen werden.

Ein Block von 212 kodierten und punktierten Bits,
P(0) ...P(211) wird an die Bits der Inband-Signalisierung in c angehängt: c       (k+4) = P(k)       für k = 0, 1, ..., 211.

Schließlich werden 12 Klasse 2 Bits an c angehängt:
c(216+k ) = d(91+k) für k = 0, 1, ..., 11.

**CH13-HS:**

Die 285 kodierten Bits, {C(0)... C(284)}:

C(3k)       = u(k)
C(3k+1)     = u(k)+u(k-1)+u(k-2)+u(k-3)+u(k-6)+C(3k-5)+ C(3k-8)+C(3k-14)+C(3k-17)
C(3k+2)     = u(k)+u(k-1)+ u(k-4)+u(k-6)+C(3k-4)+C(3k-7)+ C(3k-11)+ C(3k-16)

für k = 0, 1, ..., 94; u(k) = 0 für k<0; 0(k) = 0 für k<0
werden punktiert, so daß 73 kodierte Bits:
{C(12*j+5), C(12*j+11) für j = 0, 1, ..., 11 C(12*j+5), C(12*j+8), C(12*j+11) für j = 12, 13, ..., 22} und die Bits C(1), C(2), C(4), C(7), C(8), C(14), C(242), C(254), C(266), C(274), C(277), C(278), C(280), C(281), C(283) und C(284) nicht übertragen werden.

Ein Block von 212 kodierten und punktierten Bits, P(0)...P(211) wird an die Bits der Inband-Signalisierung in c angehängt: c(k+4) = P(k) für k = 0, 1, ..., 211. Schließlich werden 12 Klasse 2 Bits an c angehängt:

c(216+k ) = d(91+k) für k = 0, 1, ..., 11.

Die gezeigten Polynome des systematischen rekursiven Kodes (G13 bis G17) im AMR (siehe Fig 5) wurden aus zwei Gründen verwendet:

- sie haben optimale Eigenschaften für die Punktierung, d. h. die Anpassung der Datenrate an die Übertragungsrate des Funkkanals, und
- Zähler- oder Nennerpolynom sind jeweils die auch im ursprünglichen AMR Kanalkodiervorschlag (siehe Tdoc SMG 147/98) verwendeten Polynome. Die notwendigen Änderungen gegenüber dem Originalvorschlag sind somit minimal.

Für den AMR Kanalkodierer sind mit geringen Einschränkungen bei der Leistungsfähigkeit auch die bisher im GSM-System für Sprach-, Daten- und Signalisierungsinformation verwendeten Polynome einsetzbar. Dies kann an Stelle der oben beschriebenen Polynome oder als komplettes alternatives Kanalkodierschema erfolgen. Der Vorteil liegt in der nochmals erweiterten Kompatibilität, da teilweise ältere, existierende Hardware-Komponenten im Kanaldekoder nur die Verwendung der bisherigen GSM-Polynome erlauben.

In Fig 6 ist eine Basisstation BS gezeigt, die im Empfangsfall über eine Antenne A empfangene Signale in einem Empfänger verstärkt, filtert, ins Basisband umsetzt und digitalisiert. Es folgt eine Kanaldekodierung (1. Schritt), die mit in vorhandenen Basisstationen BS installierten Dekodiereinrichtungen erfolgen kann. D.h. die Schaltungstechnik kann unverändert bleiben. Es folgt eine Nachverarbeitung (2. Schritt) der dekodierten Daten, die programmtechnisch realisiert ist. Diese Nachverarbeitung besteht aus einer Faltungskodierung mit der Rate 1 mit dem Nennerpolynom der jeweiligen Rate.

Diese Nachverarbeitung ist dadurch von geringer Komplexität und wird z.B. durch ein zusätzliches Programm in einem DSP (digital signal processor) durchgeführt.

Bezogen z.B. auf die Rate CH0-FS bedeutet dies, daß der Block mit 255 Bits am Ausgang des Dekodierers mit dem Polynom:

$$G(D) = (1 + D + D^2 + D^3 + D^5)$$

kodiert werden muß, um die 255 Original-Bits zu erhalten. Die Anzahl der Datenbits bleibt hierbei konstant, d.h. aus einem aktuellen Datenbit am Eingang dieser Nachverarbeitung wird unter Zuhilfenahme vergangener Eingangsbits genau ein Originalbit gewonnen.

Die beschriebenen Kodier- und Dekodierverfahren können sowohl in Basisstationen BS als auch in Mobilstationen MS verwendet werden.

**Patentansprüche**

1. Verfahren zur Kanalkodierung und -dekodierung in einem GSM-Mobilfunksystem, bei dem

   - für die Übertragung über eine Funkschnittstelle zwischen einer Basisstation (BS) und einer Teilnehmerstation (MS) sendeseitig eine Kanalkodierung durchgeführt wird, die rekursive systematische Kodes verwendet,
   - zu kodierende Sprachinformationen zunächst entsprechend ihrer Empfindlichkeit gegenüber Übertragungsfehlern und/oder einer ihnen zugeordneten Priorität geordnet und in zumindest erste und zweite Sprachinformationen unterteilt werden,
   - für erste Sprachinformationen eine Kanalkodierung durchgeführt wird, die in einem ersten Kodierschritt Fehlerschutzkodes für eine zyklische Redundanzprüfung und in einem zweiten Kodierschritt rekursive systematische Kodes mit einem Zählerpolynom und einem Nennerpolynom verwendet,
   - für zweite Sprachinformationen eine Kanalkodierung durchgeführt wird, die rekursive systematische Kodes mit einem Zählerpolynom und einem Nennerpolynom verwendet,

   **dadurch gekennzeichnet, daß**

   - empfangsseitig eine Kanaldekodierung mit aufeinanderfolgenden nicht-rekursiven Einzelschritten durchgeführt wird,
   - nach einer Kanaldekodierung mit dem Zählerpolynom eine Nachverarbeitung auf der Basis des Nennerpolynoms durchgeführt wird.

2. Verfahren nach Anspruch 1, bei dem die Fehlerschutzkodes für die zyklische Redundanzprüfung mit dem Generatorpolynom

$$g\,(D) = D^6 + D^5 + D^3 + D^2 + D^1 + 1$$

erzeugt werden.

3. Verfahren nach einem der Ansprüche 1 oder 2, bei dem die rekursiven systematischen Kodes mit dem Generatorpolynom

$$g(D) = 1 + D + D^3 + D^4 / 1 + D^3 + D^4$$

oder

$$g(D)=1+D+D^4+D^6/1+D^2+D^3+D^5+D^6$$

erzeugt werden.

4. Verfahren nach Anspruch 1, bei dem
die Nachverarbeitung mit programmtechnischen Mitteln durchgeführt wird.

5. Verfahren nach einem der Ansprüche 1 bis 4, bei dem empfangsseitig a-priori-Wissen aus einer vorherigen Dekodierung gewonnen wird, und dieses a-priori-Wissen bei einer nachfolgenden Kanaldekodierung verwendet wird.

6. Verfahren nach einem der Ansprüche 1 bis 5, bei dem
die rekursiven systematischen Kodes innerhalb eines adaptiven Multiraten-Kodierers eingesetzt werden, wobei entsprechend der Übertragungsbedingungen ein Kodierer ausgewählt wird.

7. Verfahren nach einem der Ansprüche 1 bis 5, bei dem
von den zwei Polynomen der rekursiven systematischen Kodes mindestens ein Polynom eines bisher im GSM-Mobilfunksystem verwendeten nichtrekursiven systematischen Kode verwendet wird.

8. Basisstation (BS) für ein GSM-Mobilfunksystem,
die für die Übertragung über eine Funkschnittstelle zu einer Teilnehmerstation (MS) eine Kanalkodierung durchführt, die rekursive systematische Kodes verwendet, und derart ausgestaltet ist, daß

- zu kodierende Sprachinformationen zunächst entsprechend ihrer Empfindlichkeit gegenüber Übertragungsfehlern und/oder einer ihnen zugeordneten Priorität geordnet und in zumindest erste und zweite Sprachinformationen unterteilt werden,
- für erste Sprachinformationen eine Kanalkodierung durchgeführt wird, die in einem ersten Kodierschritt Fehlerschutzkodes für eine zyklische Redundanzprüfung und in einem zweiten Kodierschritt rekursive systematische Kodes mit einem Zählerpolynom und einem Nennerpolynom verwendet,
- für zweite Sprachinformationen eine Kanalkodierung durchgeführt wird, die rekursive systematische Kodes mit einem Zählerpolynom und einem Nennerpolynom verwendet,

**dadurch gekennzeichnet, daß**

- eine Kanaldekodierung mit aufeinanderfolgenden nicht-rekursiven Einzelschritten durchgeführt wird,
- nach einer Kanaldekodierung mit dem Zählerpolynom eine Nachverarbeitung auf der Basis des Nennerpolynoms durchgeführt wird.

9. Basisstation (BS) nach Anspruch 8, bei der
die Fehlerschutzkodes für die zyklische Redundanzprüfung mit dem Generatorpolynom

$$g\,(D)=D^6+D^5+D^3+D^2+D^1+1$$

erzeugt werden.

10. Basisstation (BS) nach einem der Ansprüche 8 oder 9, bei der
die rekursiven systematischen Kodes mit dem Generatorpolynom

$$g(D)=1+D+D^3+D^4/1+D^3+D^4$$

oder

$$g(D)=1+D+D^4+D^6/1+D^2+D^3+D^5+D^6$$

erzeugt werden.

**11.** Teilnehmerstation (MS) für ein GSM-Mobilfunksystem,
die für die Übertragung über eine Funkschnittstelle zu einer Basisstation (BS) eine Kanalkodierung durchführt, die rekursive systematische Kodes verwendet, und derart ausgestaltet ist, daß

- zu kodierende Sprachinformationen zunächst entsprechend ihrer Empfindlichkeit gegenüber Übertragungsfehlern und/oder einer ihnen zugeordneten Priorität geordnet und in zumindest erste und zweite Sprachinformationen unterteilt werden,
- für erste Sprachinformationen eine Kanalkodierung durchgeführt wird, die in einem ersten Kodierschritt Fehlerschutzkodes für eine zyklische Redundanzprüfung und in einem zweiten Kodierschritt rekursive systematische Kodes mit einem Zählerpolynom und einem Nennerpolynom verwendet,
- für zweite Sprachinformationen eine Kanalkodierung durchgeführt wird, die rekursive systematische Kodes mit einem Zählerpolynom und einem Nennerpolynom verwendet,

**dadurch gekennzeichnet, daß**

- eine Kanaldekodierung mit aufeinanderfolgenden nicht-rekursiven Einzelschritten durchgeführt wird,
- nach einer Kanaldekodierung mit dem Zählerpolynom eine Nachverarbeitung auf der Basis des Nennerpolynoms durchgeführt wird.

**12.** Teilnehmerstation (MS) nach Anspruch 11, bei der
die Fehlerschutzkodes für die zyklische Redundanzprüfung mit dem Generatorpolynom

$$g(D) = D^6 + D^5 + D^3 + D^2 + D^1 + 1$$

erzeugt werden.

**13.** Teilnehmerstation (MS) nach einem der Ansprüche 11 oder 12, bei der
die rekursiven systematischen Kodes mit dem Generatorpolynom

$$g(D) = 1 + D + D^3 + D^4 / 1 + D^3 + D^4$$

oder

$$g(D) = 1 + D + D^4 + D^6 / 1 + D^2 + D^3 + D^5 + D^6$$

erzeugt werden.

**Claims**

**1.** Method for channel coding and decoding in a GSM mobile radio system, in which

- channel coding which uses recursive systematic codes is performed at the transmitting end for the transmission via a radio interface between a base station (BS) and a subscriber station (MS),
- voice information to be coded is first ordered in accordance with its sensitivity to transmission errors and/or a priority allocated to it and is subdivided into at least first and second voice information,
- channel coding which uses error protection codes for a cyclic redundancy check in a first coding step and recursive systematic codes with a numerator polynomial and a denominator polynomial in a second coding step is performed for first voice information,
- channel coding which uses recursive systematic codes with a numerator polynomial and a denominator polynomial is performed for second voice information, **characterized in that**
- channel decoding with successive non-recursive single steps is performed at the receiving end,
- post-processing is performed on the basis of the denominator polynomial after channel decoding with the numerator polynomial.

2. Method according to Claim 1, in which the error protection codes for the cyclic redundancy check are generated with the generator polynomial

$$g(D)=D^6+D^5+D^3+D^2+D^1+1.$$

3. Method according to one of Claims 1 or 2, in which the recursive systematic codes are generated with the generator polynomial

$$g(D)=1+D+D^3+D^4/1+D^3+D^4$$

or

$$g(D)=1+D+D^4+D^6/1+D^2+D^3+D^5+D^6.$$

4. Method according to Claim 1, in which the post-processing is performed with programming means.

5. Method according to one of Claims 1 to 4, in which a priori knowledge is obtained from a previous decoding at the receiving end and this a priori knowledge is used in subsequent channel decoding.

6. Method according to one of Claims 1 to 5, in which the recursive systematic codes are used within an adaptive multirate coder, a coder being selected in accordance with the transmission conditions.

7. Method according to one of Claims 1 to 5, in which, of the two polynomials of the recursive systematic codes, at least one polynomial of a non-recursive systematic code previously used in the GSM mobile radio system is used.

8. Base station (BS) for a GSM mobile radio system which performs, for transmission via a radio interface to a subscriber station (MS), channel coding which uses recursive systematic codes and is designed in such a manner that

- voice information to be coded is first ordered in accordance with its sensitivity to transmission errors and/or a priority allocated to it and is subdivided into at least first and second voice information,
- channel coding which uses error protection codes for a cyclic redundancy check in a first coding step and recursive systematic codes with a numerator polynomial and a denominator polynomial in a second coding step is performed for first voice information,
- channel coding which uses recursive systematic codes with a numerator polynomial and a denominator polynomial is performed for second voice information, **characterized in that**
- channel decoding with successive non-recursive single steps is performed,
- post-processing is performed on the basis of the denominator polynomial after channel decoding with the numerator polynomial.

9. Base station (BS) according to Claim 8, in which the error protection codes for the cyclic redundancy check are generated with the generator polynomial

$$g(D)=D^6+D^5+D^3+D^2+D^1+1.$$

10. Base station (BS) according to one of Claims 8 or 9, in which the recursive systematic codes are generated with the generator polynomial

$$g(D)=1+D+D^3+D^4/1+D^3+D^4$$

or

$$g(D)=1+D+D^4+D^6/1+D^2+D^3+D^5+D^6.$$

**11.** Subscriber station (MS) for a GSM mobile radio system which performs, for the transmission via a radio interface to a base station (BS), channel coding which uses recursive systematic codes and is designed in such a manner that

- voice information to be coded is first ordered in accordance with its sensitivity to transmission errors and/or a priority allocated to it and is subdivided into at least first and second voice information,
- channel coding which uses error protection codes for a cyclic redundancy check in a first coding step and recursive systematic codes With a numerator polynomial and a denominator polynomial in a second coding step is performed for first voice information,
- channel coding which uses recursive systematic codes with a numerator polynomial and a denominator polynomial is performed for second voice information, **characterized in that**
- channel decoding with successive non-recursive single steps is performed,
- post-processing is performed on the basis of the denominator polynomial after channel decoding with the numerator polynomial.

**12.** Subscriber station (MS) according to Claim 11, in which the error protection codes for the cyclic redundancy check are generated with the generator polynomial

$$g(D)=D^6+D^5+D^3+D^2+D^1+1.$$

**13.** Subscriber station (MS) according to one of Claims 11 or 12, in which the recursive systematic codes are generated with the generator polynomial

$$g(D)=1+D+D^3+D^4/1+D^3+D^4$$

or

$$g(D)=1+D+D^4+D^6/1+D^2+D^3+D^5+D^6.$$

**Revendications**

**1.** Procédé de codage et décodage de canal dans un système de radiocommunication mobile GSM, dans lequel

- un codage de canal utilisant des codes récursifs systématiques est exécuté, sur le côté d'émission, pour la transmission entre une station de base (BS) et une station d'abonné (MS) par le biais d'une interface radio,
- les informations vocales à coder sont d'abord ordonnées et divisées en au moins des premières et des secondes informations vocales en fonction de leur sensibilité aux erreurs de transmission et/ou d'une priorité qui leur est attribuée,
- on exécute pour les premières informations vocales un codage de canal qui utilise, dans une première étape de codage, des codes de protection contre les erreurs pour un contrôle de redondance cyclique et, dans une seconde étape de codage, des codes récursifs systématiques avec un polynôme numérateur et un polynôme dénominateur,
- on exécute pour les secondes informations vocales un codage de canal qui utilise des codes récursifs systématiques avec un polynôme numérateur et un polynôme dénominateur,

**caractérisé en ce que**

- on exécute, sur le côté de réception, un décodage de canal comportant des étapes individuelles non récursives consécutives,
- un post-traitement est exécuté, après un décodage de canal avec le polynôme numérateur, sur la base du polynôme dénominateur.

**2.** Procédé selon la revendication 1, dans lequel le code de protection contre les erreurs pour le contrôle de redondance cyclique est produit avec le polynôme générateur

$$g(D) = D^6 + D^5 + D^3 + D^2 + D^1 + 1.$$

3. Procédé selon l'une des revendications 1 ou 2, dans lequel les codes récursifs systématiques sont produits avec le polynôme générateur

$$g(D) = 1 + D + D^3 + D^4 / 1 + D^3 + D^4$$

ou

$$g(D) = 1 + D + D^4 + D^6 / 1 + D^2 + D^3 + D^5 + D^6$$

4. Procédé selon la revendication 1, dans lequel le post-traitement est exécuté par des moyens techniques de programmation.

5. Procédé selon l'une des revendications 1 à 4, dans lequel on obtient, sur le côté de réception, une connaissance à priori à partir d'un décodage antérieur et on utilise cette connaissance à priori lors d'un décodage de canal subséquent.

6. Procédé selon l'une des revendications 1 à 5, dans lequel les codes récursifs systématiques sont utilisés à l'intérieur d'un codeur à débit multiple adaptatif, un codeur étant sélectionné en fonction des conditions de transmission.

7. Procédé selon l'une des revendications 1 à 5, dans lequel, sur les deux polynômes des codes récursifs systématiques, on utilise au moins un polynôme d'un code non récursif systématique utilisé jusqu'à présent dans le système de radiocommunication mobile GSM.

8. Station de base (BS) pour un système de radiocommunication mobile GSM, qui exécute, pour la transmission vers une station d'abonné (MS) par le biais d'une interface radio, un codage de canal utilisant des codes récursifs systématiques et est exécutée de manière à ce que

   - les informations vocales à coder sont d'abord ordonnées et divisées en au moins des premières et des secondes informations vocales en fonction de leur sensibilité aux erreurs de transmission et/ou d'une priorité qui leur est attribuée,
   - on exécute pour les premières informations vocales un codage de canal qui utilise, dans une première étape de codage, des codes de protection contre les erreurs pour un contrôle de redondance cyclique et, dans une seconde étape de codage, des codes récursifs systématiques avec un polynôme numérateur et un polynôme dénominateur,
   - on exécute pour les secondes informations vocales un codage de canal qui utilise des codes récursifs systématiques avec un polynôme numérateur et un polynôme dénominateur,

   **caractérisée en ce que**

   - on exécute un décodage de canal comportant des étapes individuelles non récursives consécutives,
   - un post-traitement est exécuté, après un décodage de canal avec le polynôme numérateur, sur la base du polynôme dénominateur.

9. Station de base (BS) selon la revendication 8, dans laquelle les codes de protection contre les erreurs pour le contrôle de redondance cyclique sont produits avec le polynôme générateur

$$g(D) = D^6 + D^5 + D^3 + D^2 + D^1 + 1.$$

10. Station de base (BS) selon l'une des revendications 8 ou 9, dans laquelle les codes récursifs systématiques sont produits avec le polynôme générateur

$$g(D) = 1 + D + D^3 + D^4 / 1 + D^3 + D^4$$

ou

$$g(D) = 1 + D + D^4 + D^6 / 1 + D^2 + D^3 + D^5 + D^6.$$

**11.** Station d'abonné (MS) pour un système de radiocommunication mobile GSM qui exécute, pour la transmission vers une station de base (BS) par le biais d'une interface radio, un codage de canal utilisant des codes récursifs systématiques et est exécutée de manière à ce que

- les informations vocales à coder sont d'abord ordonnées et divisées en au moins des premières et des secondes informations vocales en fonction de leur sensibilité aux erreurs de transmission et/ou d'une priorité qui leur est attribuée,
- on exécute pour les premières informations vocales un codage de canal qui utilise, dans une première étape de codage, des codes de protection contre les erreurs pour un contrôle de redondance cyclique et, dans une seconde étape de codage, des codes récursifs systématiques avec un polynôme numérateur et un polynôme dénominateur,
- on exécute pour les secondes informations vocales un codage de canal qui utilise des codes récursifs systématiques avec un polynôme numérateur et un polynôme dénominateur,

**caractérisée en ce que**

- on exécute un décodage de canal comportant des étapes individuelles non récursives consécutives,
- un post-traitement est exécuté, après un décodage de canal avec le polynôme numérateur, sur la base du polynôme dénominateur.

**12.** Station d'abonné (MS) selon la revendication 11, dans laquelle les codes de protection contre les erreurs pour le contrôle de redondance cyclique sont produits avec le polynôme générateur

$$g(D) = D^6 + D^5 + D^3 + D^2 + D^1 + 1$$

**13.** Station d'abonné (MS) selon l'une des revendications 11 ou 12, dans laquelle les codes récursifs systématiques sont produits avec le polynôme générateur

$$g(D) = 1 + D + D^3 + D^4 / 1 + D^3 + D^4$$

ou

$$g(D) = 1 + D + D^4 + D^6 / 1 + D^2 + D^3 + D^5 + D^6.$$

# Fig. 1

(Stand der Technik)

# Fig. 2

nichtsytematischer nichtrekursiver Kode mit Gedächtnis 4 und Rate 1/2, analog zu GSM/TCHFS

# Fig. 3

identischer rekursiver systematischer Faltungscode mit Gedächtnis 4 und Rate 1/2

# Fig. 4

| Inband-Daten<br>2 bits | Sprachrahmen<br>95..244 bits | | Inband-Daten<br>2 bits | Sprachrahmen<br>95..244 bits |

interface 0 .........

| | Sortierung<br>in: 95..159 bits<br>out: 95..159 bits | Klasse 2<br>12..52 bits | | Sortierung<br>in: 95..244 bits<br>out: 95..244 bits |

id

interface 1 .........

| Blockkode<br>in: 2 bits<br>out: 4 bits | CRC + tail<br>in: 83..123 bits<br>out: 95..134 bits | | Blockkode<br>in: 2 bits<br>out: 8 bits | CRC + tail<br>in: 95..244 bits<br>out: 107..255 bits |

ic

interface 2 .........

| | Faltungskode<br>:K=6 oder 7:<br>Rate 1/3..1/2<br>in: 95..134 bits<br>out: 172..212 bits | | | Faltungskode<br>:K=6 oder 7:<br>Rate 1/4..1/2<br>in: 107..255 bits<br>out: 448 bits |

interface 3 ...............

| Neuordnung und Aufteilung<br>+stealing flag<br>in: 228 bits<br>out: 4 Blöcke | | Neuordnung und Aufteilung<br>+stealing flag<br>in: 456 bits<br>out: 8 Blöcke |

| Diagonale<br>Verwürfelung<br>in: 4 Blöcke<br>out: Block-<br>paare | | Diagonale<br>Verwürfelung<br>in: 8 Blöcke<br>out: Block-<br>paare |

interface 4 _____ Verschlüsselung _____

# Fig. 5

im GSM-Mobilfunksystem in unterschiedlichen Kanälen verwendete Polynome

$G0 = 1 + D^3 + D^4$

$G1 = 1 + D + D^3 + D^4$

$G2 = 1 + D^2 + D^4$

$G3 = 1 + D + D^2 + D^3 + D^4$

$G4 = 1 + D^2 + D^3 + D^5 + D^6$        TCH/AMR-FS, TCH/AMR-HS

$G5 = 1 + D + D^4 + D^6$        TCH/AMR-FS, TCH/AMR-HS

$G6 = 1 + D + D^2 + D^3 + D^4 + D^6$

$G7 = 1 + D + D^2 + D^3 + D^5$        TCH/AMR-FS, TCH/AMR-HS

$G8 = 1 + D^2 + D^4 + D^5$        TCH/AMR-FS, TCH/AMR-HS

$G9 = 1 + D^3 + D^4 + D^5$        TCH/AMR-FS

$G10 = 1 + D + D^2 + D^3 + D^6$        TCH/AMR-FS, TCH/AMR-HS

$G11 = 1 + D^2 + D^3 + D^4 + D^5 + D^6$        TCH/AMR-FS

$G12 = 1$        TCH/AMR-FS, TCH/AMR-HS

$G13 = G8 / G7$        TCH/AMR-FS, TCH/AMR-HS

$G14 = G9 / G7$        TCH/AMR-FS

$G15 = G10 / G4$        TCH/AMR-FS, TCH/AMR-HS

$G16 = G5 / G4$        TCH/AMR-FS, TCH/AMR-HS

$G17 = G11 / G4$        TCH/AMR-FS

| | |
|---|---|
| TCH/AMR-FS | Nutzdatenkanal, adaptive Multiratenkodierung, Fullrate |
| TCH/AMR-HS | Nutzdatenkanal, adaptive Multiratenkodierung, Halfrate |

## Fig. 6